# EUROPÄISCHE PATENTSCHRIFT

(11) **EP 2 939 308 B1**
(45) Veröffentlichungstag und Bekanntmachung des Hinweises auf die Patenterteilung: **17.05.2017**
(21) Anmeldenummer: 13824590.7
(22) Anmeldetag: 23.12.2013
(51) Int. Cl.: H01Q 1/22, H01Q 9/42, H01Q 21/06, H01Q 1/42, H01Q 19/10, H01Q 21/00, H01L 23/66, H01L 23/522, H01Q 1/38

(54) **CHIP-ANTENNE, ELEKTRONISCHES BAUELEMENT UND HERSTELLUNGSVERFAHREN DAFÜR**
CHIP ANTENNA, ELECTRONIC COMPONENT, AND METHOD FOR PRODUCING SAME
ANTENNE MONOPUCE, COMPOSANT ÉLECTRONIQUE ET LEUR PROCÉDÉ DE FABRICATION

(30) Priorität: 27.12.2012 DE 102012224458; 29.04.2013 DE 102013207829
(43) Veröffentlichungstag der Anmeldung: 04.11.2015
(73) Patentinhaber: IHP GmbH-Innovations for High Performance Microelectronics / Leibniz-Institut für innovative Mikroelektronik, 15236 Frankfurt / Oder (DE)
(72) Erfinder: WANG, Ruoyu, 15232 Frankfurt (Oder) (DE); SUN, Yaoming, 15230 Frankfurt (Oder) (DE); SCHEYTT, Johann Christoph, 46284 Dorsten (DE); KAYNAK, Mehmet, 15230 Frankfurt (Oder) (DE)
(74) Vertreter: Eisenführ Speiser
(86) Internationale Anmeldenummer: PCT/EP2013/077951
(87) Internationale Veröffentlichungsnummer: WO 2014/102260

(56) Entgegenhaltungen:
- US-A1- 2008 068 269
- US-B2- 7 943 404
- RUOYU WANG ET AL: "A micromachined double-dipole antenna for 122 140 GHz applications based on a SiGe BiCMOS technology", MICROWAVE SYMPOSIUM DIGEST (MTT), 2012 IEEE MTT-S INTERNATIONAL, IEEE, 17. Juni 2012 (2012-06-17), Seiten 1-3, XP032216857, DOI: 10.1109/MWSYM.2012.6258421 ISBN: 978-1-4673-1085-7
- ERIK JEFORS ET AL: "Micromachined Loop Antennas on Low Resistivity Silicon Substrates", IEEE TRANSACTIONS ON ANTENNAS AND PROPAGATION, IEEE SERVICE CENTER, PISCATAWAY, NJ, US, Bd. 54, Nr. 12, 1. Dezember 2006 (2006-12-01), Seiten 3593-3601, XP011151455, ISSN: 0018-926X, DOI: 10.1109/TAP.2006.886532
- GAUTHIER G P ET AL: "A 94 GHz aperture-coupled micromachined microstrip antenna", MICROWAVE SYMPOSIUM DIGEST, 1998 IEEE MTT-S INTERNATIONAL BALTIMORE, MD, USA 7-12 JUNE 1998, NEW YORK, NY, USA,IEEE, US, 7. Juni 1998 (1998-06-07), Seiten 993-996vol.2, XP032383303, DOI: 10.1109/MWSYM.1998.705159 ISBN: 978-0-7803-4471-6

## Beschreibung

Die Erfindung betrifft eine Chip-Antenne, ein elektronisches Bauelement mit einer Chip-Antenne sowie ein Herstellungsverfahren für eine solche Chip-Antenne.

Solche Chip-Antennen werden auch als on-Chip-Antennen bezeichnet. Sie finden insbesondere in drahtlosen Übertragungssystemen Verwendung, die mit Millimeterwellen bis in den Terahertz-Bereich arbeiten. Zunehmend mehr Anwendungen finden sich für Radar, die schnelle Übertragung von Daten, Bildgebungssysteme und Sensoren.

Bei den genannten hohen Frequenzen werden die Aufbau- und Verbindungstechnologien im Vergleich mit Antennen für niedrigere Frequenzen schwieriger und kostenintensiver. Andererseits ist möglich, die Antenne auf engsten Raum direkt in den Transceiver-Chip zu integrieren und damit das Aufbauprinzip zu vereinfachen, weil die Wellenlängen der zu sendenden oder empfangenden elektromagnetischen Wellen kürzer sind und somit die Antennen klein genug für eine Integration auf in dem Chip sind.

Ein Problem bei der Ausführung von Chip-Antennen ist, dass Silizium, welches in den Standard CMOS- und BiCMOS-Prozessen als Substrat verwendet wird, ein relativ schlechter Träger für Antennenstrukturen ist. Der elektrische Widerstand von Silizium ist relativ niedrig, wodurch Verluste entstehen. Zudem ist die Permittivität von Silizium relativ hoch, wodurch die Ausbreitung von Wellen durch das Substrat begünstigt wird. Dadurch erwärmt sich das Substrat, und an seinen Kanten entsteht eine Streustrahlung. All dieses verringert den Wirkungsgrad einer auf Silizium-Substraten integrierten Chip-Antenne. Überdies können bei der Integration von Chip-Antennen und elektronischen Schaltungen auf ein und demselben Chip Substratwellen unerwünschte Signale auf die elektronischen Schaltungen übertragen und so Störungen hervorrufen.

Es sind verschiedene Lösungen bekannt, den Wirkungsgrad von Chip-Antennen zu erhöhen.

Ein Ansatz besteht darin, das Substrat bis auf eine bestimmte Dicke abzudünnen, sodass eine Ausbreitung aller Wellenmoden bis auf die Mode TM0 unterdrückt wird. Dieses Verfahren funktioniert für GaAs als Substratmaterial, jedoch nicht für Siliziumsubstrate, und zwar aufgrund des schon erwähnten relativ geringen elektrischen Widerstandes von Silizium, der entsprechende Verluste bewirkt.

Weiterhin wurde versucht, durch Protonen-Implantation den elektrischen Widerstand des Siliziumsubstrats in der Nähe der Antennenstruktur zu erhöhen. Allerdings sind dafür spezielle technologische Ausrüstungen erforderlich.

Bekannt ist, mit Hilfe von mikromechanischen Technologien das Silizium unter den Leitbahnen der Antennenstruktur zu entfernen. Die Antennenstruktur wird dann nur noch durch eine dünne Membran getragen. Die Membran kann leicht brechen und zum Ausfall der Antenne führen.

Eine Ausführungsform einer Chip-Antenne, die gemeinsam mit einer einem Transceiver und einem Reflektor in einem Halbleiterchip untergebracht ist, wird in der Schrift US 7,943,404 beschrieben. Strahler der Antenne werden durch Strukturierung einer Metallebene eines Leitbahnstapels ausgebildet, der im Herstellungsprozess während des sogenannten Back-End-of-Line (BOL) auf die Oberfläche des Substrats aufgebracht wird. Zur Verbesserung der Eigenschaften der Chip-Antenne befindet sie sich in einer Region, in der der elektrische Widerstand des Substratmaterials durch eine Dotierung erhöht wurde. Zur Anpassung der Antenne an die gewünschte Frequenz wird der Abstand eines Reflektors, der sich auf der Unterseite des Substrats befindet, durch geeignete Abdünnung des Substrates eingestellt. Alternativ oder kombiniert mit einer Abdünnung befinden sich zwischen dem Reflektor und den Strahlern kreisförmige oder elliptische Gräben, die mit einem Material geringerer Dielektrizitätskonstante gefüllt sind. Dadurch ergibt sich eine mittlere Dielektrizitätskonstante, die niedriger als die des Substrats ist.

Nachteilig ist, dass eine Ausbreitung der Wellen längs der Oberfläche des Substrats nicht wirksam unterdrückt wird und dass eine Perforation des Substrates zwischen den Strahlern und dem Reflektor die mechanische Festigkeit des Chips erheblich herabsetzt.

Eine erfindungsgemäße Chipantenne nach Anspruch 1 umfasst gemäß einem Vorrichtungsaspekt der vorliegenden Erfindung mindestens einen Strahler, der sich parallel zu einer Hauptoberfläche eines Halbleitersubstrats erstreckt. Der Strahler ist auf einer inselartigen Trägerzone des Halbleitersubstrats angeordnet, die von mindestens einem vollständig mit einem Gas gefüllten Graben umgeben ist, welcher das Halbleitersubstrat in dessen gesamter Tiefenerstreckung durchdringt und durch mindestens einen Haltesteg überbrückt ist, welcher eine tragende Verbindung zwischen der Trägerzone und dem übrigen Halbleitersubstrat bildet.
Die Chip-Antenne der vorliegenden Erfindung zeichnet sich zunächst durch ihre mechanische Robustheit aus. Sie ermöglicht gegenüber bekannten Lösungen eine Reduzierung von Verlusten und ermöglicht es daher, einen hohen Wirkungsgrad zu erzielen, der als Verhältnis der Nutzleistung zur Summe aus Nutzleistung und Verlustleistung der Antenne definiert ist. Die Strahler der Antenne sind jeweils auf einer Zone des Substrates (Trägerzone) aufgebracht, die vom übrigen Teil des Substrates durch einen oder mehrere Gräben getrennt ist und nur einen oder mehrere durch Haltestege mit dem übrigen Teil des Substrates verbunden ist, wobei die Gräben vollständig durch das Substrat hindurchgehen. Unter den Strahlern befinden sich keine Gräben. Durch das Vorsehen der inselartigen Trägerzone sind die Verluste der Antenne gering, die durch die Leitfähigkeit des Substratmaterials entstehen. Eine laterale Ausbreitung der Wellen innerhalb des Substrates wird durch die Gräben wirksam unterbunden. Sie können auf der Grundlage der erfindungsgemäßen Struktur in weiter unten beschriebenen Ausführungsformen durch geeignete geometrische Ausbildung der Trägerzone weiter reduziert werden.
Darüber hinaus eignet sich die erfindungsgemäße Antenne in besonderer Weise dazu, mit geringem Aufwand im Rahmen eines Standard-CMOS- oder BiCMOS-Prozess hergestellt werden. Dies wird weiter unten im Zusammenhang mit bevorzugten Ausführungsformen näher erläutert.
Nachfolgend werden Ausführungsformen der erfindungsgemäßen Chipantenne beschrieben.

Es können in unterschiedlichen Ausführungsformen der Erfindung verschiedene Typen von Chip-Antennen verwendet werden. Die Chip-Antenne ist in solchen unterschiedlichen Ausführungsformen beispielsweise als Monopol-, Dipol- oder als Multipol-Antenne ausgebildet. Der Strahler ist in verschiedenen Varianten beispielsweise in Form eines Längssteifens, einer Helix, eines Mäanders, oder einer rechteckigen Metallfläche (patch) ausgebildet.

Viele Ausführungsbeispiele sehen die Ausbildung einer Vielzahl von mindestens zwei Strahlern vor, die elektrisch leitfähig miteinander verbunden sind.

In bevorzugten Ausführungsformen ist der Strahler oder sind die Strahler oberhalb des Halbleitersubstrats in einem Leitbahnstapel angeordnet, der mindestens eine Metallebene enthält. Die Strahler können in diesen Ausführungsform aufwandsarm durch die Strukturierung einer der Metallebenen M1 bis M5 des Leitbahnstapels, die üblicherweise für die Verbindung von mikroelektronischen Schaltungen verwendet werden, ausgeformt werden.

Bevorzugt ist der Graben durch Wegätzen nur des Halbleitersubstrats hergestellt. Durch solches selektives Wegätzen wird der Leitbahnstapel nicht freigeätzt. Das Substrat kann beispielsweise ein Siliziumwafer sein, während der Leitbahnstapel neben metallischen Leitbahnen im Wesentlichen ein Dielektrikum, also zum Beispiel Siliziumdioxid enthält. In einer solchen oder einer ähnlichen Materialkonstellation lässt sich das Silizium des Substrats selektiv ätzen.

Je nach Antennentyp können auch mehrere Ebenen, also Flächen mit unterschiedlichem senkrechten Abstand von der Hauptoberfläche des Halbleitersubstrats für die Ausformung von Strahlern und Gegenelektroden verwendet werden. Entweder sind in solchen Ausführungsformen also unterschiedliche Strahler der Antenne oder sind zum einen der Strahler und zum anderen eine Gegenelektrode auf unterschiedlichen Ebenen in demselben inselartig isolierten Bereich angeordnet.

Als solche unterschiedliche Ebenen können bei diesen Ausführungsformen beispielsweise die schon erwähnten Metallebenen eines Leitbahnstapels genutzt werden. Zusätzlich oder alternativ ist in einigen Ausführungsformen mindestens ein erster der Strahler auf einer Vorderseite des Halbleitersubstrats angeordnet und mindestens ein zweiter der Strahler auf einer Unterseite des Halbleitersubstrats angeordnet. Auf der Unterseite kann zusätzlich oder alternativ auch eine Gegenelektrode angeordnet sein. Eine elektrische Verbindung zwischen solchen auf der Vorder- und der Unterseite vorhandenen Antennenelementen kann mittels durch das Substrat hindurch verlaufenden Vias (engl. through-substrate-vias, TSV) realisiert werden.

Die Vorderseite bildet in Ausführungsformen, bei denen eine mikroelektronische Schaltung in das Halbleitersubstrat integriert ist, typischerweise diejenige Seite des Halbleitersubstrats, auf der die mikroelektronische Schaltung sowie der Leitbahnstapel angeordnet ist, welcher Schaltungselemente der mikroelektronischen Schaltung miteinander verbindet. In manchen Ausführungsformen, die insbesondere keine mikroelektronische Schaltung im Halbleitersubstrat beinhalten, ist die Benennung von Vorder- und Unterseite des Substrates beliebig wählbar.

Die erfindungsgemäße Chipantenne weist in vielen Ausführungsformen mindestens zwei Strahler auf, die auf unterschiedlichen inselartigen Trägerzonen angeordnet sind und die elektrisch leitfähig miteinander verbunden sind.

Die Verluste der Antenne, die durch die Leitfähigkeit des Substratmaterials entstehen, sind besonders gering, wenn nur die durch Gräben begrenzte Trägerzone zum Tragen der Strahler in etwa der Form der Strahler angepasst ist und hinreichend klein ist. Eine laterale Ausbreitung der Wellen innerhalb des Halbleitersubstrates wird durch die Gräben in solchen Ausführungsformen besonders wirksam unterbunden. Die Trägerzone hat in solchen Ausführungsformen vorzugsweise eine geometrische Ausgestaltung, bei der an jedem dem umgebenden Graben zugewandten Randpunkt des Strahlers ein senkrechter Abstand zu einem dem Strahler zugewandten Rand des Grabens klein ist. Je geringer der Abstand ist, desto weniger Verluste werden durch das Substratmaterial (beispielsweise Silizium) hervorgerufen. Andererseits ist eine Prozesstoleranz beim Herstellen des Grabens zu berücksichtigen. Wenn der Abstand zu klein angesetzt ist, kann unter Umständen nicht zuverlässig verhindert werden, dass ein Stück des Substratmaterials unter dem Strahler weggeätzt wird. Dies würde die effektive Permittivität verändern und die Resonanzfrequenz der Antenne verstimmen. Unter Berücksichtigung der Prozesstoleranz sollte der genannten senkrechte Abstand daher vorzugsweise zwischen 50 und 300 Mikrometer, besonders bevorzugt zwischen 100 und 150 Mikrometer betragen.

Zur Erzielung ausreichender Dämpfung einerseits und einer hohen mechanischen Stabilität der Chip-Antenne andererseits ist kann die Breite der Graben optimiert werden. Ein breiterer Graben führt zwar zu besserer Isolation als ein schmalerer Graben, fordert jedoch eine größere Chipfläche und reduziert die mechanische Stabilität. Vorzugsweise hat der die Trägerzone umgebende Graben eine laterale Erstreckung (Breite) von 100 bis 400 Mikrometern, besonders bevorzugt 150 bis 300 Mikrometern.

Die mechanische Stabilität wird auch durch die Gestaltung des Haltestegs beeinflusst. Grundsätzlich sind hier verschiedene geometrische Ausführungen möglich. Der Haltesteg steht in einer bevorzugten, einfach herstellbaren Ausführungsform sowohl auf der Seite der Trägerzone als auch auf der Seite des restlichen Halbleitersubstrats entweder annähernd oder genau senkrecht vom Grabenrand ab.

Insbesondere die mechanische Festigkeit der Antenne und die Resistenz gegenüber Schwingungen wird durch die laterale Breite der Haltestege für die Trägerzone beeinflusst, die entsprechend starr ausgelegt sein können. Die Breite des Haltestegs wird jedoch auch mit Blick auf den Abstand der beiden Antennendipole, auf die Breite des Grabens und mit Blick auf den Abstand zwischen dem Grabenrand und dem Strahler bestimmt. Der Haltesteg hat bevorzugt quer zu seiner Längsrichtung eine laterale Erstreckung (Breite) von zwischen 50 und 150 Mikrometer, besonders bevorzugt zwischen 80 und 120 Mikrometer.

Eine Ausführung mit einem einzigen Haltesteg ist besonders einfach und für die Minimierung der Antennenverluste besonders günstig. Ausführungen mit mehreren Stegen können aber sinnvoll sein, um beispielsweise hochfrequenztechnisch vorteilhafte geometrische Formen von Verbindungsleitungen zwischen mehreren Trägerzonen zu realisieren.

Werden mehrere Stege verwendet, müssen diese nicht die gleiche Breite aufweisen. Es kann ein Haltesteg mit relativ größerer Breite und ein Verbindungssteg mit relativ geringerer Breite verwendet werden. Mit anderen Worten, die Funktion der Sicherung der mechanischen Stabilität der Chip-Antenne kann den verschiedenen Stegen in solchen Ausführungsformen mit unterschiedlich starker Wichtung zugeordnet sein.

Bei einer weiteren Ausführungsform der Chipantenne ist das Halbleitersubstrat mit seiner Unterseite auf einer Leiterplatte befestigt ist. Die Befestigung erfolgt insbesondere auf einer Massefläche der Leiterplatte.

Zur Optimierung der hochfrequenztechnischen Eigenschaften der Chipantenne weist das Halbleitersubstrat in bevorzugten Ausführungsformen eine vorbestimmte Dicke auf, die prozesstechnisch durch kontrolliertes Abdünnen eines Ausgangssubstrats, also beispielsweise eines Wafers, etwa in Form eines Siliziumwafers erzielt werden kann. Diese Ausführungsform ist von Bedeutung insbesondere für den Fall, dass ein Reflektor an der Unterseite des Halbleitersubstrats eingesetzt wird. Das Halbleitersubstrat weist in solchen Ausführungsformen zur Vermeidung destruktiver Interferenz eine Dicke in Tiefenrichtung auf, bei welcher eine im Substrat verlaufende, von der Antenne erzeugte, an einer Unterseite des Halbleitersubstrats reflektierte Welle mit einer im Substrat verlaufenden, von der Antenne erzeugten und nicht reflektierten Welle konstruktiv interferiert. Ein Vorteil dieser Ausführungsform ist, dass das Feld in Richtung der unreflektierten Welle doppelt so stark ist.

Als Halbleitersubstrat kommen grundsätzlich verschiedene Materialien in Frage. Die Erfindung eignet sich besonders für Halbleitersubstrate mit relativ hoher Leitfähigkeit, wie sie beispielsweise bei Siliziumsubstraten gegeben ist. Die Verwendung eines Siliziumsubstrats hat den zusätzlichen Vorteil der Ingegrationsfähigkeit der Chipantenne in hochentwickelte Herstellungstechnologien wie CMOS oder BiCMOS. Die Abmessungen der Chip-Antenne können aufgrund der hohen Permittivität des Siliziumsubstrates gering sein. Das Halbleitersubstrat ist in dazu alternativen Ausführungsformen ein Silizium-Germaniumsubstrat, ein Galliumarsenidsubstrat, oder ein Galliumnitridsubstrat, ohne mit diesen Beispielen die Verwendbarkeit anderer Substrate auszuschließen zu wollen.

Die erfindungsgemäße Chipantenne ist in vorteilhaften Weiterbildungen in einer der zuvor oder weiter unten beschriebenen Ausführungsformen in ein elektronisches Bauelement integriert, welches außer einer solchen Chipantenne mindestens eine mit der Chipantenne elektrisch verbundenen elektronischen Schaltkreis enthält. Der elektronische Schaltkreis ist in bevorzugten Ausführungsbeispielen monolithisch im Halbleitersubstrat integriert. Auf diese Weise können Sender-, Empfänger oder Senderempfänger-Chips für Hochfrequenzstrahlung mit integrierter Chipantenne bereitgestellt werden, die von den oben beschriebenen Vorteilen der erfindungsgemäßen Chipantenne profitieren. Aber auch elektronischen Bauelemente, die als System-in-Package ausgebildet sind, bilden vorteilhafte Weiterbildungen der Erfindung. Bei einem System-in-Package ist der elektronische Schaltkreis in einem zweiten, mit dem ersten Halbleitersubstrat als System-In-Package in einer gemeinsamen Verpackung verbunden Halbleitersubstrat angeordnet ist. Bei manchen solcher Ausführungsformen hat das Halbleitersubstrat der Chipantenne keinen monolithisch integrierten elektronischen Schaltkreis.

Einen Verfahrensaspekt der vorliegenden Erfindung nach Anspruch 15 bildet ein Verfahren zur Herstellung einer Chipantenne, umfassend
- Herstellen einer inselartigen Trägerzone in einem Halbleitersubstrat durch Herstellen mindestens eines, vollständig mit einem Gas gefüllten Graben, der den inselartig isolierten Bereich umgibt,
- wobei der Graben durch das Halbleitersubstrat hindurch in dessen gesamter Tiefe hindurch ausgebildet wird und mindestens ein den Graben überbrückender Haltesteg belassen wird, welcher eine tragende Verbindung zwischen dem inselartig isolierten Bereich des Halbleitersubstrats und dem übrigen Bereich des Halbleitersubstrats bildet,
- Herstellen mindestens eines Strahlers der Chipantenne, der sich parallel zu einer Hauptoberfläche des die Chipantenne tragenden Halbleitersubstrats in dem inselartig isolierten Bereich erstreckt,und der auf der inselartigen Trägerzone des Halbleitersubstrats angeordnet ist,
- wobei das Ausbilden des Grabens entweder vor oder nach dem Herstellen des mindestens einen Strahlers der Chipantenne erfolgt.

Das Verfahren dieses zweiten Aspektes der Erfindung teilt die Vorteile der Chipantenne des ersten Aspekts der Erfindung. Das Ausbilden des Grabens kann wie erwähnt vor oder nach dem Herstellen der Chipantenne erfolgen. Bevorzugt erfolgt die Ätzung jedoch nach der Fertigung aller anderen Komponenten, also auch nach dem Herstellen der Chipantenne.
Die in das Substrat eingebrachten Gräben werden in einer bevorzugten Ausführungsform des Verfahrens von der Unterseite des Substrates aus durch Trockenätzen hergestellt. Für die Anwendung wird das Halbleitersubstrat vorzugsweise auf eine bestimmte Dicke abgedünnt und direkt auf die Massefläche einer Leiterplatte aufgeklebt.
In einer anderen Ausführungsform wird eine Metallebene auf die Unterseite des Chips aufgebracht, die durch ein Via mit der Oberseite elektrisch verbunden wird. Die Abdünnung des Chips erfolgt in einer Weise, dass die reflektierte Welle mit der nichtreflektierten Welle konstruktiv interferiert.

Nachfolgend werden weitere Ausführungsbeispiele unter Bezugnahme auf die Figuren beschrieben. In den Figuren zeigen:
- Fig. 1: eine schematische Draufsicht einer Chip-Antenne gemäß einem Ausführungsbeispiel der Erfindung;
- Fig. 2: eine schematische Schnittansicht der Chip-Antenne der Fig. 1 entlang der Linie A-A;
- Fig. 3: eine schematische perspektivische Ansicht der Chip-Antenne der Fig. 1 und 2;
- Fig. 4: eine schematische Querschnittansicht eines Beispiels einer Chip-Antenne.

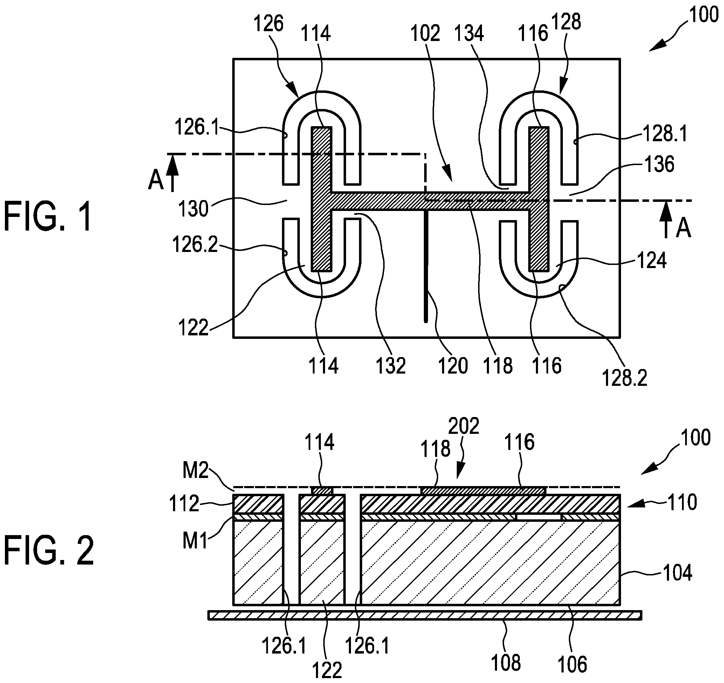

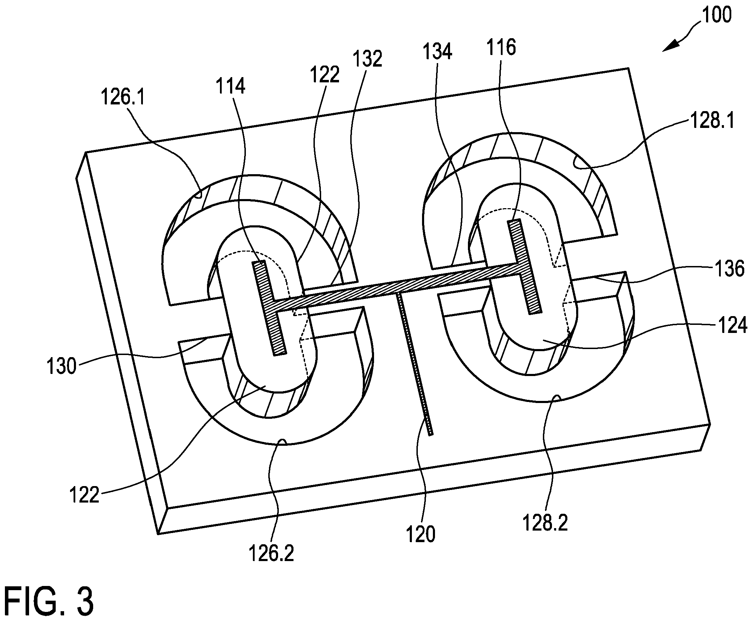

Nachfolgend wird unter paralleler Bezugnahme der Fig. 1 bis 3 ein erstes Ausführungsbeispiel einer Chip-Antenne 102 gemäß der vorliegenden Erfindung beschrieben, die in ein elektronischen Bauelements in Form eines Chips 100 integriert ist. Die Darstellungen in den Fig. 1 bis 3 sind lediglich schematisch. Insbesondere ist jeweils nur ein lateraler Ausschnitt des Chips 100 dargestellt, der die Chip-Antenne 102 enthält. Weitere laterale Abschnitte des Chips 100, die beispielsweise monolithisch integrierte elektronische Schaltkreise enthalten, sind der Einfachheit der Darstellung halber hier nicht grafisch repräsentiert. In Fig. 3 wird teilweise auf Details verzichtet, die in den beiden Darstellungen der Fig. 1 und 2 eingezeichnet sind. Dies dient allein der besseren grafischen Darstellbarkeit.
Die Chip-Antenne 102 ist auf einem Halbleitersubstrat ausgebildet, das hier ein Siliziumwafer 104 ist. Der Siliziumwafer 104 ist ein übliches, in CMOS- oder BiCMOS-Prozessen eingesetztes Halbleitersubstrat.
Der Siliziumwafer 104 ist vorliegend mit an seiner Unterseite 106 mit einem metallischen Reflektor 108 verbunden. Der Reflektor kann beispielsweise eine Massefläche einer Leiterplatte sein, auf die der Chip 100 mit seiner Unterseite 106 festgeklebt ist. In einer alternativen, hier nicht dargestellten Ausführungsform ist der Reflektor eine auf der Unterseite 106 des Siliziumwafers 104 durch einen Abscheideprozess aufgebrachte Metallebene. Diese kann durch ein durch den Wafer hindurch verlaufendes Via mit der Substratoberseite und der dort angeordneten Chip-Antenne 102 elektrisch verbunden wird.

Die Chip-Antenne 102 ist auf einer Oberseite des Siliziumwafers 104 angeordnet, und zwar auf einer zweiten Ebene M2 eines Leitbahnstapels 110. Die Leitbahnebene M2 bildet im vorliegenden Ausführungsbeispiel die höchste Leitbahnebene des Leitbahnstapels 110. Unter ihr ist lediglich eine weitere Leitbahnebene, nämlich die unterste Leitbahnebene M1 angeordnet. Die beiden Leitbahnebenen M1 und M2 sind durch ein Zwischenebenen-Dielektrikum (engl. interlevel dielectric, ILD) 112 voneinander elektrisch isoliert.

Die Chip-Antenne 102 auf der zweiten Leitbahnebene M2 hat zwei Strahler 114 und 116. Die Strahler 114 und 116 sind jeweils als gerade, stabförmige Leitbahnabschnitte realisiert. Die beiden Strahler 114 und 116 sind durch einen ebenfalls als metallischer Leitbahnabschnitt ausgebildeten Antennensteg 118 miteinander elektrisch leitfähig verbunden. Die beiden Strahler 1140 und 1160 zweigen vom Antennensteg 118 jeweils in der Mitte ihrer Längserstreckung ab. So bilden die beiden Strahler 114 und 116 zusammen mit dem Antennensteg 118 in etwa die Form des Großbuchstaben H, d.h. eines gefalteten Dipols. Eine Antennenspeisung 120 ist in den Fig. 1 und 3 schematisch angedeutet.

Bei der Chip-Antenne 102 bildet die erste Metallisierungsebene M1 des Leitbahnstapels 110 eine Masseebene. Unterhalb der Strahler 114 und 116 ist auf der Metallisierungsebene M1 jedoch kein Metall vorgesehen.

Die beiden Strahler 114 und 116 sind im Gegensatz zum Antennensteg 118 auf inselartigen Trägerzonen 122 und 124 des Halbleitersubstrats 104 ausgebildet. Wie besonders deutlich in der Querschnittzeichnung der Fig. 2 und der perspektiven Ansicht der Fig. 3 erkennbar ist, sind die beiden Trägerzonen 122 und 124 durch Gräben 126 und 128 vom übrigen Siliziumwafer 104 isoliert. Die Gräben 126 und 128 sind bei dem Chip 100 des vorliegenden Ausführungsbeispiels mit Luft gefüllt. Sie können jedoch auch mit einem anderen Gas oder Vakuum gefüllt sein. Eine auch nur teilweise Füllung der Gräben mit einem festen dielektrischen Material ist im Rahmen der vorliegenden Erfindung ausgeschlossen.

Durch Haltestege 130, 132 und Haltestege 134 und 136 sind die beiden Trägerzonen 122 und 124 mechanisch jeweils an den umgebenden Siliziumwafer 104 gekoppelt. Die Verbindungsstege 130 bis 134 teilen die beiden Gräben 126 und 128 in jeweils zwei Grabenteile 126.1, 126.2 sowie 128.1, 128.2. Abgesehen von den Haltestegen 130 bis 136 werden die beiden Strahler 114 und 116 vollständig von den Gräben 126 und 128 umgeben. Die Grabenbreite beträgt typischerweise etwa 150 bis 300 Mikrometer. Die Trägerzonen sind in Ihrer geometrischen Form der Stabform der Strahler 114 und 116 angepasst. Im vorliegenden Beispiel sind sie ebenfalls etwa stabförmig, jedoch mit abgerundeten Längsenden. Der Abstand zwischen den Strahlern und dem umgebenden Graben wird so klein wie prozesstechnisch möglich gehalten. Typischerweise liegt er im Bereich von 100-150 Mikrometer. Auf diese Weise können die Antennenverluste reduziert werden.
Durch Verwendung abgerundeter Längsenden der Trägerzonen kann der Abstand vom Grabenrand zum Rand des Dipols vorteilhafterweise stets gleichgehalten werden.
Die Haltestege 130 bis 136 sorgen für eine mechanisch stabile Anbindung der so gebildeten Trägerzonen 122 und 124 an den Siliziumwafer 104. Die Breite der Haltestege 132 und 134 beträgt beispielsweise 100 Mikrometer.
Im vorliegenden Ausführungsbeispiel sind die äußeren Haltestege 130 und 136 breiter als die innen Haltestege 132 und 134. Die beiden äußeren Haltestege 130 und 136 bilden auf diese Weise die für die mechanische Stabilität wesentliche Verbindung der jeweiligen Trägerzonen 122 und 124 an den Siliziumwafer 104. Die beiden inneren Verbindungsstege 132 und 134 dienen im Wesentlichen zur Herstellung einer elektrischen Verbindung der beiden Strahler 114 und 116 durch den Antennensteg 118, welcher über die beiden Verbindungstege 132 und 134 verläuft. Es ist im Rahmen der vorliegenden Erfindung auch möglich, zumindest eine der Trägerzonen durch nur einen Haltesteg mit dem umgebenden Substrat zu verbinden.
Die Herstellung des Chips 100 beinhaltet übliche Prozessschritte eines CMOS- oder BiCMOS-Prozesses, ergänzt um das Herstellen der inselartigen Trägerzonen 122 und 124. Dafür werden die Gräben 126 und 128 von der Unterseite 106 des Siliziumwafers 104 her durch reaktives Ionenätzen ausgebildet. Dieser Schritt erfolgt im vorliegenden Ausführungsbeispiel nach Herstellung des Leitbahnstapels 110 mit den oben beschriebenen Leitbahnstrukturen der Chip-Antenne 102. Die Herstellung der Chip-Antenne 102 kann durch diese Prozessführung in bekannte CMOS- oder BiCMOS-Prozesse im Rahmen der backend-Prozessierung eingebunden werden.

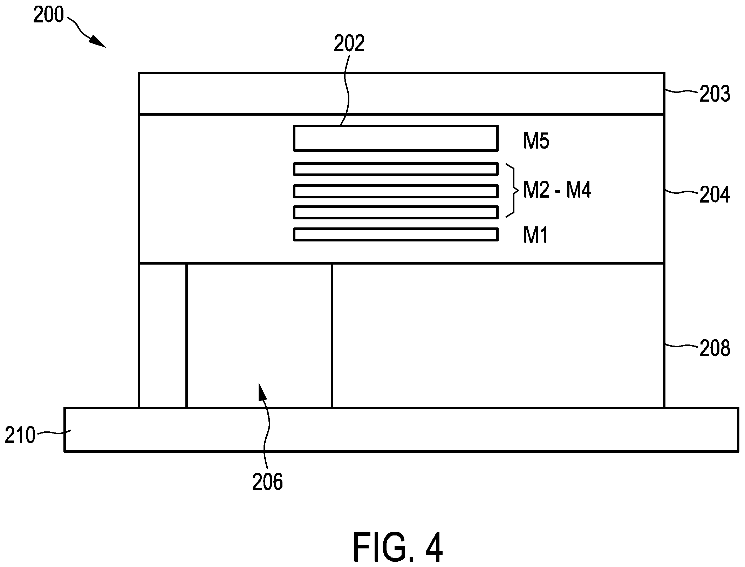

Fig. 4 zeigt eine schematische Querschnittdarstellung eines Beispiels einer Chip-Antenne 202 auf einem Chip 200. Das vorliegende Beispiel ähnelt in vielen Merkmalen dem ersten Ausführungsbeispiel, welches in den Fig. 1 bis 3 dargestellt ist. Daher ist mit Fig. 4 allein eine der Querschnittdarstellung der Fig. 2 entsprechende Querschnittdarstellung des Ausführungsbeispiels gezeigt. Die nachfolgende Beschreibung konzentriert sich vorwiegend auf Unterschiede des vorliegenden Beispiels gegenüber dem oben beschriebenen ersten Ausführungsbeispiels.

Bei dem Chip 200 des vorliegenden Beispiels ist die Chip-Antenne 202 in einem Leitbahnstapel 204, der in diesem Beispiel fünf Metallebenen M1 bis M5 aufweist, auf der obersten Metallebene M5 ausgebildet und von einer Passivierungsschicht 203 bedeckt. Ihre Form entspricht der im ersten Ausführungsbeispiel gezeigten. Strahler und den Antennensteg sind also auf der fünften Metallebene M5 angeordnet, jedoch in der vereinfachten Darstellung der Fig. 4 nicht näher ausgeführt. Die Leitbahnebenen M2 bis M4 enthalten in an sich bekannter Weise Leitbahnen zur Verbindung elektronischer Bauelemente einer im Chip 200 monolithisch integrierten elektronischen Schaltung (nicht dargestellt) und können auch zur Verbindung der elektronischen Bauelemente mit der Antenne verwendet werden. Die Leitbahnebene M1 bildet im vorliegenden Beispiel eine Masse-Ebene. Zwischen den Metallebenen M1 bis M5 sind jeweils Zwischenebenen-Dielektrika angeordnet, wie es an sich von Leitbahnstapeln nach herkömmlichen Technologien bekannt ist.

Ein Graben 206 erstreckt sich im vorliegenden Beispiel von einer Unterseite eines Siliziumsubstrats 208 durch das Siliziumsubstrat hindurch, jedoch nicht in den Leitbahnstapel 204 hinein. Der Graben enden also vor oder unmittelbar am substratseitigen Ende des Leitbahnstapels.
Das Siliziumsubstrat 204 ist mit seiner Unterseite auf einem Reflektor 210 befestigt, der die Effizienz der Chip-Antenne erhöht.

Der Strahler ist in einem anderen Beispiel auf einem allein von dielektrischem Material gebildeten Schichtstapel ausgebildet (hier nicht dargestellt). Lateral neben diesem Schichtstapel können in dieser Variante Leitbahnen angeordnet sein.

## Patentansprüche

1. Chipantenne (102), umfassend mindestens einen Strahler (114), der sich parallel zu einer Hauptoberfläche eines Halbleitersubstrats (104) erstreckt, **dadurch gekennzeichnet, dass** der Strahler auf einer inselartigen Trägerzone (122) des Halbleitersubstrats angeordnet ist, die von mindestens einem vollständig mit einem Gas gefüllten Graben (126) umgeben ist, welcher das Halbleitersubstrat in dessen gesamter Tiefenerstreckung durchdringt und durch mindestens einen Haltesteg (130) überbrückt ist, welcher eine tragende Verbindung zwischen der Trägerzone und dem übrigen Halbleitersubstrat bildet.

2. Chipantenne nach Anspruch 1, bei der der Strahler oberhalb des Halbleitersubstrats in einem Leitbahnstapel (110) angeordnet ist, der mindestens eine Metallebene (M2) enthält.

3. Chipantenne nach Anspruch 1 oder 2, bei der entweder unterschiedliche Strahler der Antenne oder zum einen der Strahler und zum anderen eine Gegenelektrode auf unterschiedlichen Ebenen in demselben inselartig isolierten Bereich angeordnet sind.

4. Chipantenne nach einem der vorstehenden Ansprüche, welche mindestens zwei Strahler umfasst, die auf unterschiedlichen inselartigen Trägerzonen angeordnet sind und die elektrisch leitfähig miteinander verbunden sind.

5. Chipantenne nach Anspruch 3 oder 4, bei der mindestens ein erster der Strahler auf einer Vorderseite des Halbleitersubstrats angeordnet ist und mindestens ein zweiter der Strahler auf einer Unterseite (106) des Halbleitersubstrats angeordnet ist.

6. Chipantenne nach einem der vorstehenden Ansprüche, bei der an jedem dem umgebenden Graben zugewandten Randpunkt des Strahlers ein senkrechter Abstand zu einem dem Strahler zugewandten Rand des Grabens zwischen 100 und 150 Mikrometer beträgt.

7. Chipantenne nach einem der vorstehenden Ansprüche, bei der der Graben eine laterale Erstreckung 150 bis 300 Mikrometer hat.

8. Chipantenne nach einem der vorstehenden Ansprüche, bei der der Haltesteg quer zu seiner Längsrichtung eine laterale Erstreckung von zwischen 80 und 120 Mikrometer hat.

9. Chipantenne nach einem der vorstehenden Ansprüche, bei der das Halbleitersubstrat mit seiner Unterseite auf einer Leiterplatte befestigt ist.

10. Chipantenne nach einem der vorstehenden Ansprüche, bei der das Halbleitersubstrat an einer Unterseite einen Reflektor (108) aufweist und eine Dicke in Tiefenrichtung hat, bei welcher eine im Substrat verlaufende, von der Antenne erzeugte, an der Unterseite des Halbleitersubstrats reflektierte Welle mit einer im Substrat verlaufenden, von der Antenne erzeugten und nicht reflektierten Welle konstruktiv interferiert.

11. Chipantenne nach einem der vorstehenden Ansprüche, bei der das Halbleitersubstrat ein Siliziumsubstrat oder ein Galliumarsenidsubstrat oder ein Indiumphosphidsubstrat oder ein Galliumnitridsubstrat oder ein Saphirsubstrat oder ein Glassubstrat ist.

12. Elektronisches Bauelement, mit einer Chipantenne nach einem der vorstehenden Ansprüche und mindestens einem mit der Chipantenne elektrisch verbundenen elektronischen Schaltkreis.

13. Elektronisches Bauelement nach Anspruch 12, bei dem der elektronische Schaltkreis monolithisch im Halbleitersubstrat integriert ist.

14. Elektronisches Bauelement nach Anspruch 12, bei dem der elektronische Schaltkreis in einem zweiten, mit dem ersten Halbleitersubstrat als System-In-Package in einer gemeinsamen Verpackung verbunden Halbleitersubstrat angeordnet ist.

15. Verfahren zur Herstellung einer Chipantenne (102), umfassend
- Herstellen einer inselartigen Trägerzone (122) in einem Halbleitersubstrat (104) durch Herstellen mindestens eines, vollständig mit einem Gas gefüllten Graben (126), der den inselartig isolierten Bereich umgibt,
- wobei der Graben durch das Halbleitersubstrat hindurch in dessen gesamter Tiefe hindurch ausgebildet wird und mindestens ein den Graben überbrückender Haltesteg (130) belassen wird, welcher eine tragende Verbindung zwischen dem inselartig isolierten Bereich des Halbleitersubstrats und dem übrigen Bereich des Halbleitersubstrats bildet,
- Herstellen mindestens eines Strahlers (114) der Chipantenne, der sich parallel zu einer Hauptoberfläche des Halbleitersubstrats in dem inselartig isolierten Bereich erstreckt, und der auf der inselartigen Trägerzone des Halbleitersubstrats angeordnet ist,
- wobei das Ausbilden des Grabens entweder vor oder nach dem Herstellen des mindenstens einen Strahlers der Chipantenne erfolgt.

## Claims

1. Chip antenna (102), comprising at least one emitter (114) which extends parallel to a main surface of a semiconductor substrate (104), **characterized in that** the emitter is arranged on an island-like support zone (122) of the semiconductor substrate, the support zone being surrounded by at least one trench (126) which is completely filled with a gas, the trench passing through the entire depth of the semiconductor substrate and being bridged by at least one retaining web (130) which forms a supporting connection between the support zone and the rest of the semiconductor substrate.

2. Chip antenna according to claim 1, wherein the emitter is arranged above the semiconductor substrate in a conductor path stack (110) containing at least one metal level (M2).

3. Chip antenna according to claim 1 or 2, wherein either different emitters of the antenna, or the emitter on the one hand and a counter electrode on the other hand, are arranged at different levels in the same island-like isolated area.

4. Chip antenna according to any of the preceding claims, comprising at least two emitters which are arranged on different island-like support zones and are electrically conductively connected to each other.

5. Chip antenna according to claim 3 or 4, wherein at least a first one of the emitters is arranged on a front side of the semiconductor substrate and at least a second one of the emitters is arranged on an underside (106) of the semiconductor substrate.

6. Chip antenna according to any of the preceding claims, wherein at each emitter edge point facing the surrounding trench there is a perpendicular distance of between 100 and 150 micrometres to a trench edge facing the emitter.

7. Chip antenna according to any of the preceding claims, wherein the trench has a lateral extension of 150 to 300 micrometres.

8. Chip antenna according to any of the preceding claims, wherein the retaining web has a lateral extension transverse to its longitudinal direction of between 80 and 120 micrometres.

9. Chip antenna according to any of the preceding claims, wherein the semiconductor substrate is fixed by its underside to a circuit board.

10. Chip antenna according to any of the preceding claims, wherein the semiconductor substrate has a reflector (108) on one underside and has a thickness in the depth direction, wherein a wave generated by the antenna and running in the substrate and reflected at the underside of the semiconductor substrate interferes constructively with a non-reflected wave generated by the antenna and running in the substrate.

11. Chip antenna according to any of the preceding claims, wherein the semiconductor substrate is a silicon substrate or a gallium arsenide substrate or an indium phosphide substrate or a gallium nitride substrate or a sapphire substrate or a glass substrate.

12. Electronic component, with a chip antenna according to any of the preceding claims and with at least one electronic circuit which is electrically connected to the chip antenna.

13. Electronic component according to claim 12, wherein the electronic circuit is monolithically integrated in the semiconductor substrate.

14. Electronic component according to claim 12, wherein the electronic circuit is arranged in a second semiconductor substrate connected as a system-in-package to the first semiconductor substrate in a common package.

15. Method for manufacturing a chip antenna (102), comprising
- producing an island-like support zone (122) in a semiconductor substrate (104) by producing at least one trench (126) completely filled with a gas, which surrounds the island-like isolated area,
- wherein the trench is formed through the entire depth of the semiconductor substrate and at least one retaining web (130) bridging the trench is left, which forms a supporting connection between the island-like isolated area of the semiconductor substrate and the remaining area of the semiconductor substrate,
- producing at least one emitter (114) of the chip antenna which extends parallel to a main surface of the semiconductor substrate in the island-like isolated area, and which is arranged on the island-like support zone of the semiconductor substrate,
- wherein the trench is formed either before or after the at least one emitter of the chip antenna is produced.

## Revendications

1. Antenne associée à une puce (102), comprenant au moins un émetteur (114) qui s'étend parallèlement à une surface principale d'un substrat semi-conducteur (104), **caractérisée en ce que** l'émetteur est disposé sur une zone porteuse (122) du type îlot qui est entourée par au moins une tranchée (126) entièrement remplie de gaz qui traverse le substrat semi-conducteur dans la totalité de son étendue en profondeur et qui est enjambée par au moins une barrette de retenue (130) qui forme une liaison porteuse entre la zone porteuse et le reste du substrat semi-conducteur.

2. Antenne associée à une puce selon la revendication 1, dans laquelle l'émetteur est disposé au-dessus du substrat semi-conducteur dans une pile de pistes conductrices (110) qui contient au moins un niveau métallique (M2).

3. Antenne associée à une puce selon la revendication 1 ou 2, dans laquelle soit différents émetteurs de l'antenne, soit d'une part l'émetteur et d'autre part une contre-électrode sont disposés sur différents niveaux dans la même zone isolée du type îlot.

4. Antenne associée à une puce selon l'une des revendications précédentes, qui comprend au moins deux émetteurs qui sont disposés sur différentes zones porteuses du type îlot et qui sont raccordés l'un à l'autre de façon électriquement conductrice.

5. Antenne associée à une puce selon la revendication 3 ou 4, dans laquelle au moins un premier des émetteurs est disposé sur un côté avant du substrat semi-conducteur et au moins un deuxième des émetteurs est disposé sur un côté inférieur (106) du substrat semi-conducteur.

6. Antenne associée à une puce selon l'une des revendications précédentes, dans laquelle, sur chaque point de bord de l'émetteur tourné vers la tranchée environnante, une distance perpendiculaire par rapport à un bord de la tranchée tourné vers l'émetteur est comprise entre 100 et 150 micromètres.

7. Antenne associée à une puce selon l'une des revendications précédentes, dans laquelle la tranchée a une étendue latérale comprise entre 150 et 300 micromètres.

8. Antenne associée à une puce selon l'une des revendications précédentes, dans laquelle la barrette de retenue a, transversalement à sa direction longitudinale, une étendue latérale comprise entre 80 et 120 micromètres.

9. Antenne associée à une puce selon l'une des revendications précédentes, dans laquelle le substrat semi-conducteur est fixé sur un circuit imprimé par son côté inférieur.

10. Antenne associée à une puce selon l'une des revendications précédentes, dans laquelle le substrat semi-conducteur présente sur un côté inférieur un réflecteur (108) et a une épaisseur dans le sens de la profondeur pour laquelle une onde se déplaçant dans le substrat, produite par l'antenne, réfléchie sur le côté inférieur du substrat semi-conducteur interfère de façon constructive avec une onde se déplaçant dans le substrat, produite par l'antenne et non réfléchie.

11. Antenne associée à une puce selon l'une des revendications précédentes, dans laquelle le substrat semi-conducteur est un substrat en silicium ou un substrat en arséniure de gallium ou un substrat en phosphure d'indium ou un substrat en nitrure de gallium ou un substrat en saphir ou un substrat en verre.

12. Composant électronique, avec une antenne associée à une puce selon l'une des revendications précédentes et au moins un circuit électronique raccordé électriquement à l'antenne associée à une puce.

13. Composant électronique selon la revendication 12, dans lequel le circuit électronique est intégré de façon monolithique dans le substrat semi-conducteur.

14. Composant électronique selon la revendication 12, dans lequel le circuit électronique est disposé dans un deuxième substrat semi-conducteur raccordé au premier substrat semi-conducteur en tant que système dans un boîtier *(System-In-Package)* dans un boîtier commun.

15. Procédé de fabrication d'une antenne associée à une puce (102), comprenant
- la fabrication d'une zone porteuse (122) du type îlot dans un substrat semi-conducteur (104) par la fabrication d'au moins une tranchée (126) entièrement remplie de gaz qui entoure la zone isolée du type îlot,
- la tranchée étant constituée à travers le substrat semi-conducteur dans toute sa profondeur, et au moins une barrette de retenue (130) enjambant la tranchée étant laissée, laquelle forme une liaison porteuse entre la zone isolée du type îlot et le reste de la zone du substrat semi-conducteur,
- la fabrication d'au moins un émetteur (114) de l'antenne associée à une puce qui s'étend parallèlement à une surface principale du substrat semi-conducteur dans la zone isolée du type îlot,
et qui est disposé sur la zone porteuse du type îlot du substrat semi-conducteur,
- la formation de la tranchée s'effectuant soit avant soit après la fabrication de l'au moins un émetteur de l'antenne associée à une puce.
